(19) Europäisches Patentamt
European Patent Office
Office européen des brevets

(11) EP 0 736 555 A2

(12) # EUROPEAN PATENT APPLICATION

(43) Date of publication:
**09.10.1996 Bulletin 1996/41**

(21) Application number: **96870047.6**

(22) Date of filing: **05.04.1996**

(51) Int. Cl.$^6$: **C08G 59/20**, C08G 59/24, C09D 163/10, C09J 163/10, C09D 11/00

(84) Designated Contracting States:
**BE DE FR GB IT NL**

(30) Priority: **05.04.1995 JP 104877/95**

(71) Applicants:
- **U C B, S.A.**
  **B-1050 Bruxelles (BE)**
- **DAICEL CHEMICAL INDUSTRIES, LTD.**
  **Chiyoda-ku Tokyo 100 (JP)**

(72) Inventors:
- **Barbe, Dirk**
  **1770 Liedekerke (BE)**
- **Okumura, Koichi**
  **Ohtake-shi, Hiroshima-ken (JP)**

(74) Representative: **Debled, Thierry**
**UCB S.A.**
**Département D.T.B.**
**rue d'Anderlecht 33**
**1620 Drogenbos (BE)**

(54) **Radiation-curable epoxy resin composition**

(57) Disclosed is a photo-curable resin composition.

The photo-curable resin composition is excellent in stability of the composition, tackiness, developability, sensitivity, anti-strippability, and hydrolysis resistance compared to conventional photo-curable resin composition.



Printed by Rank Xerox (UK) Business Services
2.13.8/3.4

## Description

The present invention relates to a radiation-curable resin composition which can be cured by irradiation energy such as ultraviolet ray or electron-beam.

The radiation-curable resin composition of the present invention can provide a cured layer having an excellent adhesive property, solvent resistance, and gloss for a variety of base materials. Therefore, the radiation-curable resin composition of the present invention can be used as resin for inks, coating for plastics, coating for films, coating for metals, coating for furniture, lining material, adhesive, insulating varnish for electronics, insulating sheet, laminated sheet, printed circuit board, resist ink, encapsulating material for semiconductors.

Photo-curable resins compositions which can be cured by irradiation energy such as ultraviolet ray or electron-beam have been widely used in a variety of industries such as printing, coating, and electronics, etc.

They have advantageous properties; (1) solvent free and low pollution, (2) high speed curability and high productivity, (3) slight shrinkage in volume because of curing of 100% solids, and (4) slight thermal loss and minor adverse thermal effects to base materials, etc.

As a result, a variety of radiation-curable resin compositions have been developed as coating and adhesives for plastics, papers, and inorganic materials, etc.

A resin for radiation-curable resin compositions to be employed as coatings, inks, and adhesives, includes an epoxy(meth)acrylate resin prepared by the reaction of an epoxy resin with acrylic acid or methacrylic acid.

However, the epoxy(meth)acrylate resin has disadvantage of rigidness and brittleness in curing. For example, such epoxy(meth)acrylate resin is employed in formulating inks for paper and if the paper is bent after curing, then cured inks disadvantageously crack.

Furthermore, when such epoxy(meth)acrylate resin is employed as coating for metal plates such as iron or aluminium and if the metal plates are bent during processing, then coating layers crack, disadvantageously resulting in being difficult to process.

Still further, such epoxy(meth)acrylate resin has a disadvantage of being poor in adhesive properties to iron or aluminium. On the other hand, a radiation-curable epoxy resin is not adversely affected by oxygen during the curing process compared to a radical-polymerizable type photo-curable resin, and it is more advantageous in photo-sensitivity and adhesive property than the radical-polymerizable type resin.

In view of the drawbacks of the hitherto known epoxy resins, it is an object of the present invention to provide a radiation curable resin composition capable of providing a cured layer having an excellent adhesive property, solvent resistance, and gloss for a variety of base materials.

Therefore the present invention relates to a radiation-curable resin composition which comprises (a) 99.9 to 0.1 parts by weight of at least one epoxy compound having at least two cycloaliphatic epoxy groups, (b) 0.1 to 99.9 parts by weight of at least one epoxy compound having a (meth)acrylic group and a cycloaliphatic epoxy group, (c) about 0.1 to about 20 parts by weight of at least one cationic polymerization photo-initiator, and (d) about 0.1 to about 20 parts by weight of at least one radical polymerization initiator.

An epoxy compound (a) to be employed in the present invention may be represented by general formula;

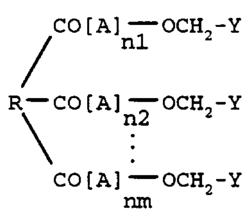

(1)

wherein R is a hydrocarbon residual group having a carbon number ranging from 1 to 30 which may have a cycloaliphatic epoxy group, structural unit A is $-O-(CR^1R^2)_a-CO-$, wherein $R^1$ and $R^2$ are independently a hydrogen atom or an alkyl group having a carbon number ranging from 1 to 9, a is an integer ranging from 4 to 8, and Y is a structural unit represented by the following formula

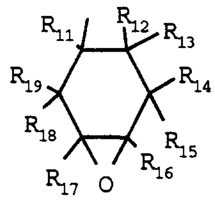

wherein $R^{11}$ to $R^{19}$ are independently a hydrogen atom or an alkyl group having a carbon number ranging from 1 to 9, n1, n2, ..... nm are 0 or an integer of at least 1, respectively, m is an integer of at least 1, and in the case when m is 1, R has a cycloaliphatic epoxy group.

The structural unit A may be derived from a lactone compound, such as delta-valerolactone, beta-methyl-delta-valerolactone epsilon-caprolactone, 3,3,5-trimethylcaprolactone, 3,5,5-trimethylcaprolactone and the like.

As the epoxy compound (a) may be mentioned 3,4-epoxycyclohexylmethyl-3,4-epoxycyclohexanecarboxylate, a caprolactone-modified compound thereof, a trimethylcaprolactone-modified compound thereof, and a valerolactone-modified compound thereof.

3,4-epoxycyclohexylmethyl-3,4-epoxycyclohexanecarboxylate and the lactone-modified compounds thereof can be prepared by the expoxidation reaction of 1,2,5,6-tetrahydrobenzyl-1,2,5,6-tetrahydrobenzoate or a lactone modified compound thereof as described in US Patent No. 5,378,736 or European Patent No. 459,913 in detail. As such compound, there are specifically exemplified Celloxide 2021, Celloxide 2021P, Celloxide 2081, Celloxide 2083, and Celloxide 2085 commercially supplied by Daicel Chemical Industries, Ltd., and ERL4289 and ERL4299 commercially supplied by Union Carbide Corporation, which are adipate-based cycloaliphatic epoxy compounds.

An epoxy compound (a) represented by the general formula (1), wherein m is 2 or 4, specifically include the following compounds;

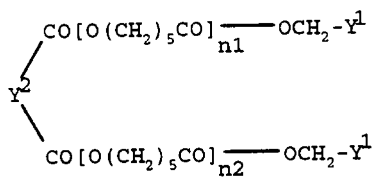

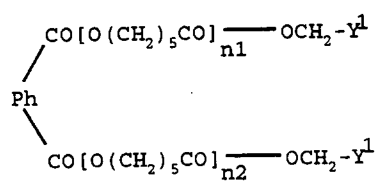

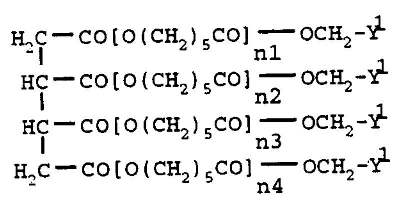

wherein n1, n2, n3, and n4 are integers ranging from 1 to 50, respectively, which may be identical or different from each other, $Y^1$ is a structural unit

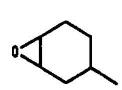 ,

and $Y^2$ is a structural unit

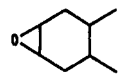 ,

Ph is a phenylene group which may have substituted groups.

Such epoxy compounds (a) are described in US Patent Nos. 5,169,965 and 5,338,879, or European Patent No. 466,596. As such compounds, there are specifically exemplified Epolead GT300, GT301, GT302, GT400, GT401, and GT403 commercially supplied by Daicel Chemical Industries, Ltd.

As epoxy compound (b), there are specifically exemplified the following compounds;

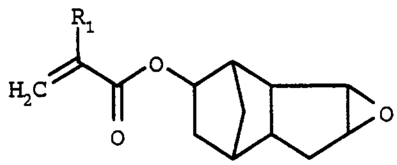

(2)

wherein $R^1$ is a hydrogen atom or methyl group,

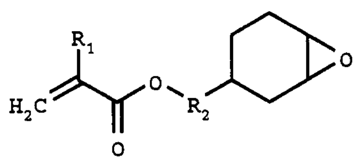

(3)

and

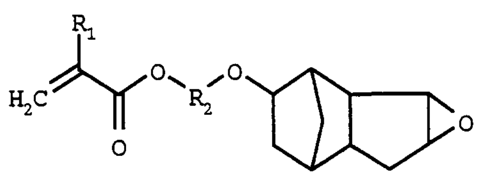

(4)

wherein $R^1$ is a hydrogen atom or a methyl group, $R^2$ is an alkylene group having a carbon number ranging from 1 to 10,

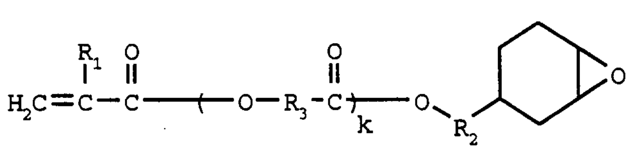

(5)

wherein $R^1$ is a hydrogen atom or a methyl group, $R^2$ is an alkylene group having a carbon number ranging from 1 to 10, $R^3$ is a residual group of hydrocarbon having a carbon number ranging from 1 to 10, and k is 0 or an integer ranging from 1 to 10,

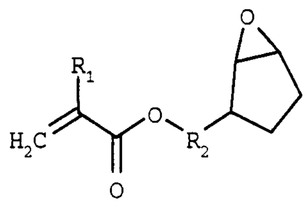

(6)

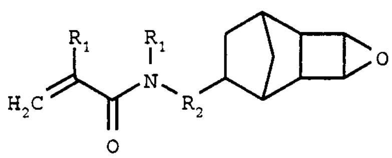

(7)

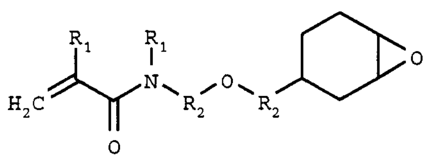

(8)

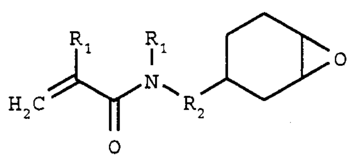

(9)

wherein, $R^1$ is a hydrogen atom or a methyl group, $R^2$ is an alkylene group having a carbon number ranging from 1 to 10,

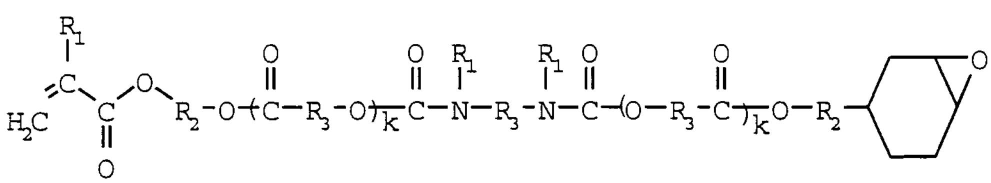

(10)

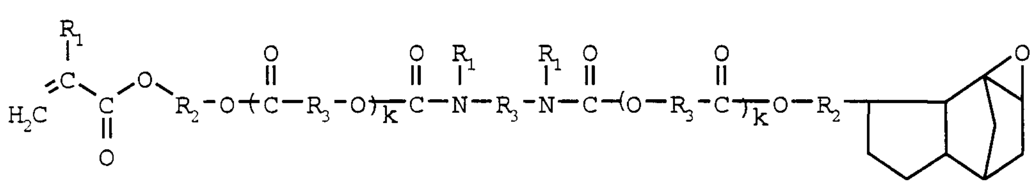

(11)

wherein, $R^1$ is a hydrogen atom or a methyl group, $R^2$ is an alkylene group having a carbon number ranging from 1 to 10, $R^3$ is a residual group of hydrocarbon having a carbon number ranging from 1 to 10, and k is 0 or an integer ranging from 1 to 10,

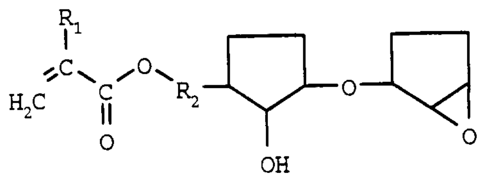

(12)

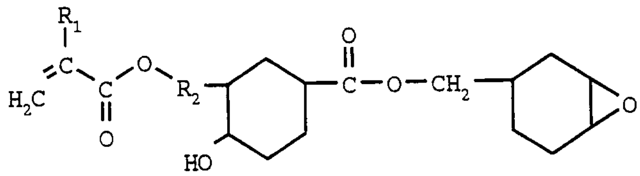

(13)

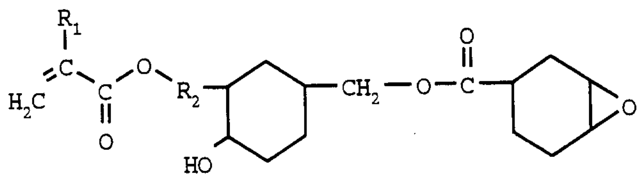

(14)

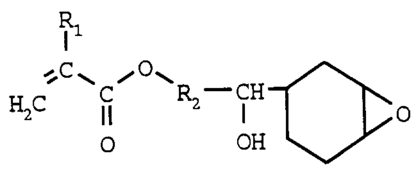

(15)

wherein, $R^1$ is a hydrogen atom or a methyl group, $R^2$ is an alkylene group having a carbon number ranging from 1 to 10,

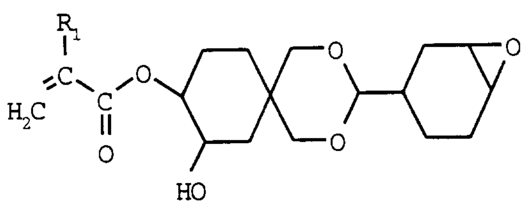

(16)

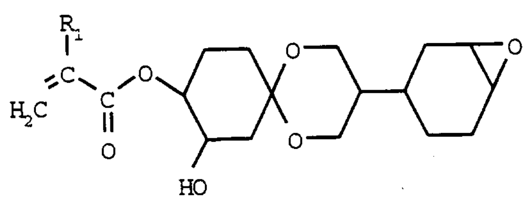

(17)

wherein, $R^1$ is a hydrogen atom or a methyl group.

Of those, there can be most preferably employed 3,4-epoxycyclohexylmethyl(meth)acrylate represented by formula (3).

The composition of the invention may further comprise at least one compound having aliphatic epoxy group such as glycidyl(meth)-acrylate, beta-methylglycidyl(meth)acrylate, allylglycidylether, and the like, in a proportion of up to 80% by weight based on the combined weight of compounds (a) and (b).

The epoxy compound (b) can be copolymerized with the compound (a) in the presence of a cationic polymerisation photo-initiator. Furthermore, since the epoxy compound (b) includes a (meth)acrylic group, it can be polymerized in the presence of a radical polymerization initiator.

The compounds (a) and (b) are preferably used in a ratio from 95 to 50% by weight in the composition of the invention.

As component (c) cationic polymerization photo-initiators, there can be employed any compounds which can generate cations by photo-irradiation, such as the following compounds.

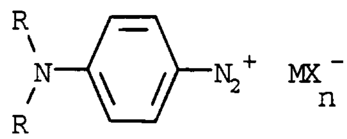

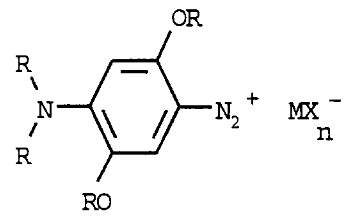

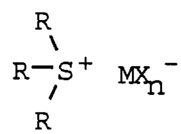

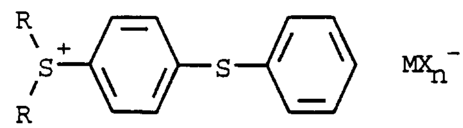

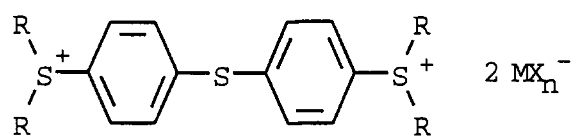

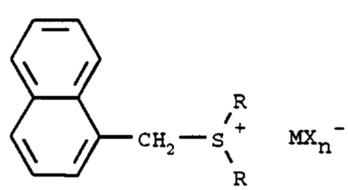

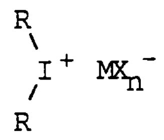

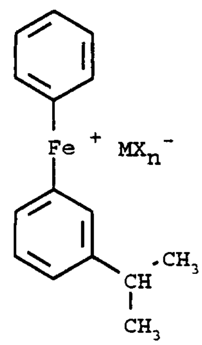

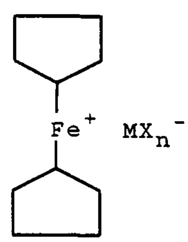

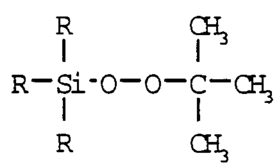

wherein R is a hydrogen atom, an alkyl group, a phenyl group, an aryl group, or a hydroxyalkyl group which may be identical or different from each other, $MX_n$- is $SbF_6$-, $AsF_6$-, $PF_6$-, or $BF_6$-.

The component (c) cationic polymerization photo-initiator is preferably employed in an amount from 1.0 to 10 parts by weight, and more preferably from 1.0 to 5.0 based on 100 parts by weight of the total amount of the components (a) and (b).

As the component (d) radical polymerization initiators, there can be employed any compounds which can generate activated radical by photo-irradiation, such as benzoin, benzoin methylether, benzoin ethylether, benzoin isopropylether, benzoin butylether, benzylmethylketal, acetoin, butyloin, toluoin, benzyl, benzophenone, p-chlorobenzophenone, and p-methoxy-benzophenone, a sulphur compound such as tetramethyltiurammonosulphide and tetramethyltiurammonodisulphide, an azo-compound such as azobisisobutyronitrile and azobisdimethyl-valeronitrile, a peroxide compound such as benzoyl peroxide and di-t-butylperoxide, etc. The component (d) radical polymerization photo-initiator may be employed solely or in combination.

The component (d) radical polymerization initiator is preferably employed in an amount from 1.0 to 10 parts by weight, and more preferably from 1.0 to 5.0 based on 100 parts by weight of the total amount of the component (a) and the component (b).

The radiation-curable resin composition of the present invention, may further comprise other epoxy compounds having at least one epoxy group, polymerizable monomers, and polymerizable oligomers, up to 50 parts by weight based on 100 parts by weight of the total amount of the component (a) and the component (b).

As the other epoxy compounds to be optionally employed, there are specifically exemplified the following compounds.

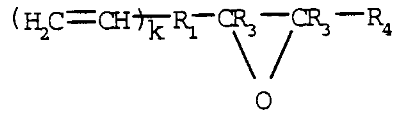

wherein $R^1$ is a hydrogen atom, an alkylene group having a carbon number ranging from 1 to 50 which may be cyclic, a phenylene group having a carbon number ranging from 1 to 50, $R^2$, $R^3$, and $R^4$ is a hydrogen atom, an alkylene group having a carbon number ranging from 1 to 50, and $R^2$ and $R^3$ may jointly be cyclic, and k is an integer ranging from 1 to 5.

The compound specifically include 4-vinylcyclohexene-1-oxide, 5-vinylbicyclo[2.2.1]hepto-2-en-2-oxide, limonene monoxide, trivinylcyclohexanemonoxide, divinylbenzenemonoxide, butadiene monoxide, and 1,2-epoxy-9-decene, etc.

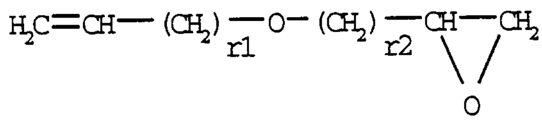

wherein r1 and r2 are integers ranging from 0 to 30 which may be identical or different from each other, allylglycidylethers of the formula

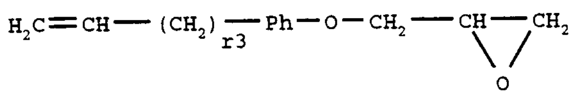

wherein Ph is a phenylene group which may have a substituted group, and r3 is an integer ranging from 0 to 30, and compounds such as AOEX24 (having average molecular weight of 196 and a carbon number ranging from 12 to 14), AOEX68 (having average molecular weight of 252 and a carbon number ranging from 15 to 18), and AOEY08 (having average molecular weight of 342 and a carbon number ranging from 20 to 30) manufactured by Daicel Chemical Industries, Ltd.

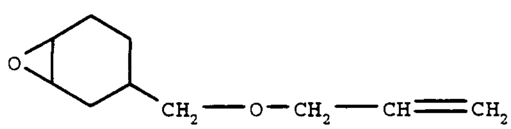

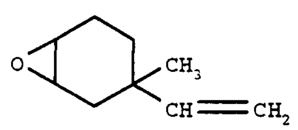

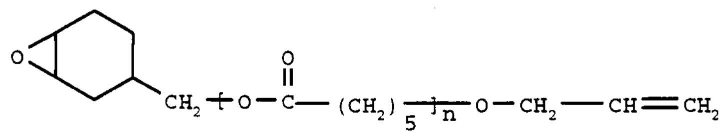

wherein n is an integer exceeding 0.

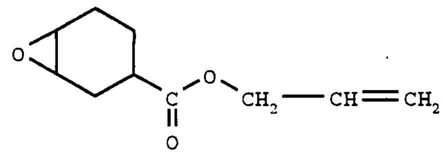

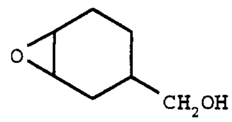

Furthermore, there can be also mixed ethyleneoxide, propyleneoxide, cyclohexyloxide, styreneoxide, vinylcyclohexeneoxide, methylated vynylcyclohexenedioxide (Celloxide 3000 manufactured by Daicel Chemical Industries, Ltd.).

As the polymerizable monomers to be optionally employed, there are specifically exemplified an alkylacrylate such as methylacrylate, ethylacrylate, isopropyl acrylate, n-butylacrylate, 2-ethylhexylacrylate, an alkylmethacrylate such as methylmethacrylate, ethylmethacrylate, isopropylmethacrylate, n-butylmethacrylate, isobutymethacrylate, n-hexylmethacrylate, 2-ethylhexylmethacrylate, lauryl methacrylate, glycidylacrylate, glycidylmethacrylate, acrylonitrile, methacrylonitrile, acrylamide, methacrylamide, an aminoalkyl methacrylate such as aminomethyl methacrylate, amino N-methylmethacrylate, amino N,N-dimethylmethacrylate, an aminoalkyl acrylate such as aminomethylacrylate, amino N-methylacrylate, aminoethyl N,N-dimethylacrylate, a styrenic monomer such as styrene, vinyltoluene, alphamethylstyrene, and vinylacetate, etc. Furthermore, there can be also employed a monoethylenic unsaturated monomer having hydroxyl group according to circumstances.

The monoethylenic unsaturated monomer having hydroxyl group includes a hydroxyalkyl(meth)acrylate such as 2-hydroxyethyl(meth)acrylate, 2-hydroxypropyl(meth)acrylate, 2-hydroxybutyl(meth)acrylate, 2-hydroxypentyl(meth)acrylate, and a lactone-modified product thereof, which are compounds having a radically polymerizable double bond. Still further, there can be also mixed bifunctional (meth)acrylates such as 1,6-hexanediol di(meth)acylate and neopentylglycol di(meth)acrylate, and trifunctional (meth)acrylates such as trimethylpropane tri(meth)acrylate, etc.

As the polymerizable oligomers to be optionally employed, there are specifically exemplified a (meth)acrylate of a polyesterpolyol, a (meth)acrylate of a polyetherpolyol, an adduct of (meth)acrylic acid to a polyepoxide, and a compound in which a hydroxy(meth)acrylate is introduced into a polyol through a polyisocyanate. In addition, in the radiation-curable resin composition of the present invention, there can be also optionally mixed a levelling agent, an antifoaming agent, an ultraviolet ray absorbent, a photo-stabilizer, an antioxidant, pigments, a thickening agent, an agent for preventing precipitation, an antistatic agent, an anti-clouding agent, and solvents, etc.

The radiation-curable resin composition of the present invention can be coated by a method such as a brush coating, spray coating, dip-coating, spin-coating, and curtain coating, etc.

In order to cure the radiation-curable resin composition of the present invention, there are preferably employed a high-pressure mercury lamp and a metal halide lamp from which an ultraviolet ray ranging from 100 to 400 nanometer is radiated. Irradiation can be carried out in air or inert gas atmosphere such as nitrogen or argon. The curing of the radiation-curable resin composition of the present invention can also be made by electron-beams.

In the following, although the present invention is specifically illustrated below by Examples, it is not limited by the Examples.

Examples 1 to 6

Coating compositions as shown in Table 1 were coated on aluminium plates, steel plates, metal plates on which a white paint is coated, and art papers so that the thickness is adjusted to 10 microns, followed by being cured by irradiation with a high-pressure mercury lamp in air.

Tables 1

| | Example | | | | | |
|---|---|---|---|---|---|---|
| | 1 | 2 | 3 | 4 | 5 | 6 |
| Composition (parts by weight) | | | | | | |
| GT 300 | 80 | | | | | |
| GT 302 | | 80 | | | | |
| CEL 2021P | | | 80 | | 60 | 60 |
| CEL 2081 | | | | 80 | | |
| CEL 3000 | | | | | 20 | |
| CYM A200 | 20 | 20 | 20 | 20 | 20 | |
| CYM M100 | | | | | | 20 |
| FX 512 | 2 | 2 | 2 | 2 | 2 | 2 |
| Irg. 651 | 1 | 1 | 1 | 1 | 1 | 1 |
| Properties | | | | | | |
| Anti-strippability | | | | | | |
| Aluminium | 5 | 5 | 5 | 5 | 5 | 5 |
| Steel | 5 | 5 | 4 | 4 | 5 | 5 |
| Coated metal | 5 | 5 | 5 | 5 | 5 | 5 |
| Art paper | 5 | 5 | 5 | 5 | 5 | 5 |
| Solvent resistance | 5 | 5 | 5 | 5 | 5 | 5 |
| Gloss | 90 | 88 | 92 | 91 | 90 | 91 |
| Bending resistance | 5 | 5 | 5 | 5 | 5 | 4 |
| Resistance to boiling water | | | | | | |
| Outer appearance | 5 | 5 | 5 | 5 | 5 | 5 |
| Anti-strippability | 5 | 5 | 5 | 5 | 5 | 5 |

Comparative Examples 1 to 3

The same procedures were repeated except that there were employed coating compositions as shown in Table 2.

Tables 2

| | Comparative Example | | |
|---|---|---|---|
| | 1 | 2 | 3 |
| Composition (parts by weight) | | | |
| EA | 80 | 80 | |
| TPGDA | 20 | | |
| FX 512 | | 2 | 2 |
| Irg. 651 | 1 | 1 | |
| Properties | | | |
| Anti-strippability | | | |
| Aluminium | 1 | 5 | 5 |
| Steel | 1 | 5 | 4 |
| Coated metal | 1 | 2 | 5 |
| Art paper | 4 | 4 | 5 |
| Solvent resistance | 5 | 3 | 1 |
| Gloss | 88 | 85 | 92 |
| Bending resistance | 1 | 3 | 5 |
| Resistance to boiling water | | | |
| Outer appearance | 5 | 5 | 2 |
| Anti-strippability | 5 | 5 | 1 |

In the Tables 1 and 2, abbreviations are as follows.

GT 300: Epolead GT 300 manufactured by Daicel Chemical Industries, Ltd. having the chemical formula described below.

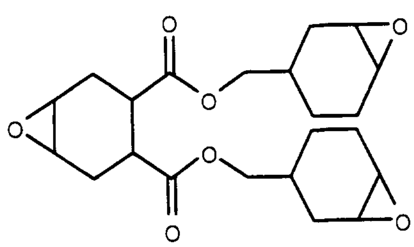

GT 302: Epolead GT 302 manufactured by Daicel Chemical Industries, Ltd. having the chemical formula described below.

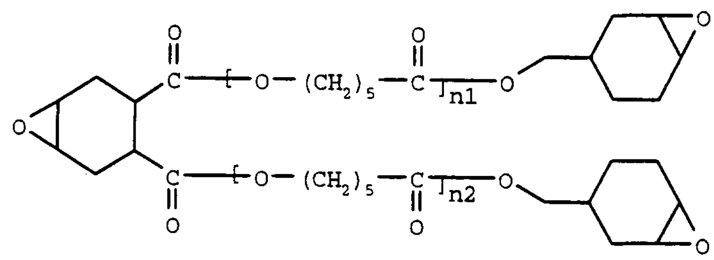

wherein n1 + n2 = average 2

CEL 2021P: purified Celloxide 2021 manufactured by Daicel Chemical Industries, Ltd. having the chemical formula described below.

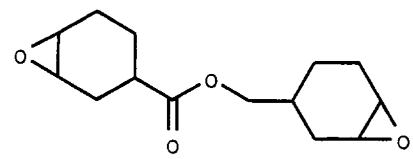

CEL 2081: Celloxide 2081 manufactured by Daicel Chemical Industries, Ltd. having the chemical formula described below.

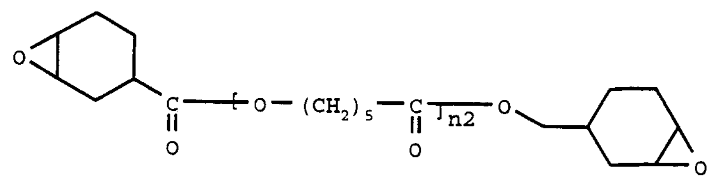

CEL 3000: Celloxide 3000 manufactured by Daicel Chemical Industries, Ltd. having the chemical formula described below.

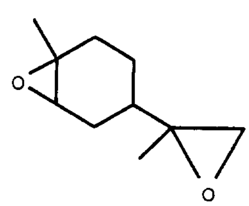

CYM A200: Cyclomer A200 manufactured by Daicel Chemical Industries, Ltd. having the chemical formula described below.

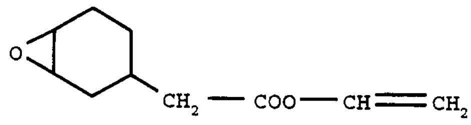

CYM M100: Cyclomer M100 manufactured by Daicel Chemical Industries, Ltd. having the chemical formula described below.

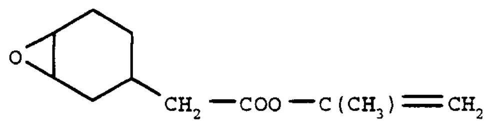

EA: A bisphenol type epoxy acrylate.

TPGDA: Tripropyleneglycoldiacrylate.

FX 512: a mixture composed of the compounds having the chemical formulae described below which are manufactured by 3M Co.

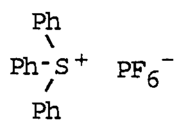

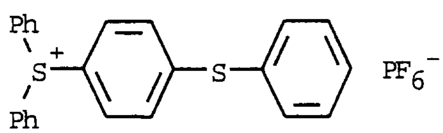

wherein Ph is a phenyl group.

Irg. 651: Irgacure 651 manufactured by Ciba-Geigy which is benzyldimethylketal.

Properties in the Tables 1 and 2 are based on the following tests.

1. Anti-strippability (a cross hatched test)
Cured layer was cut crosswise to the surface of a base material at an interval of 1 mm to form 100 pieces of a square having 1 $mm^2$. Sticking tape (Cellophane tape) was stuck on the cured layer, followed by being abruptly stripped. Evaluation was based on the following grades.

Grade 5: stripped pieces of 0
Grade 4: stripped pieces of 1-25
Grade 3: stripped pieces of 26-50
Grade 2: stripped pieces of 51-75
Grade 1: stripped pieces of 76-100

As the base material, there were employed an aluminium plate processed by chromphosphate, an unprocessed steel plate, a metal plate coated by a white paint, and an art paper.

2. Solvent resistance

The surface of cured layer was rubbed by an acetone-absorbed cotton cloth ten times, followed by being visually observed. Evaluation was based on the following grades.

Grade 5: no-changed
Grade 4: slightly whitened
Grade 3: whitened
Grade 2: remarkably whitened
Grade 1: remarkably whitened and stripped

3. Gloss

Reflection ratio was measured at the angle of 60 degree in the surface of cured layer with a glossmeter.

4. Bending resistance

Bending resistance test was carried out with a tester based on a JIS standard, followed by being visually observed.

Grade 5: no-cracked and no-removed
Grade 4: slightly cracked
Grade 3: cracked
Grade 2: slightly removed
Grade 1: removed

An attached axle has diameter of 2 mm, and test plates are aluminium plates processed by chromphosphate.

5. Resistance to boiling water

Outer appearance and anti-strippability were visually evaluated according to the following grades.

Grade 5: no-changed
Grade 4: slightly whitened
Grade 3: whitened
Grade 2: remarkably whitened
Grade 1: remarkably whitened and peeled

While the invention has been described in detail and with reference to specific embodiments thereof, it will be apparent to one skilled in the art that various changes and modifications can be made therein without departing from the spirit and scope thereof.

## Claims

1. A radiation-curable resin composition which comprises (a) 99.9 to 0.1 parts by weight of at least one epoxy compound having at least two cycloaliphatic epoxy groups, (b) 0.1 to 99.9 parts by weight of at least one epoxy compound having a (meth)acrylic group and a cycloaliphatic epoxy group, (c) about 0.1 to about 20 parts by weight of at least one cationic polymerization photo-initiator, and (d) about 0.1 to about 20 parts by weight of at least one radical polymerization initiator.

2. A radiation-curable resin composition as set forth in claim 1, wherein said epoxy compound having at least two cycloaliphatic epoxy groups is a compound having general formula;

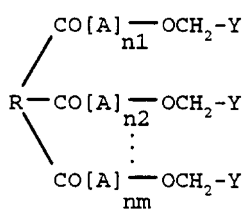

(1)

wherein R is a hydrocarbon residual group having a carbon number ranging from 1 to 30 which may have a

cycloaliphatic epoxy group, structural unit A is -O-$(CR^1R^2)_a$-CO-, wherein $R^1$ and $R^2$ are a hydrogen atom or an alkyl group having a carbon number ranging from 1 to 9, a is an integer ranging from 4 to 8, and Y is a structural unit represented by the following formula

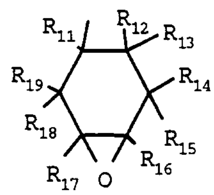

wherein $R^{11}$ to $R^{19}$ are a hydrogen atom or an alkyl group having a carbon number ranging from 1 to 9, n1, n2, ..... nm are 0 or an integer of at least 1, respectively, m is an integer of at least 1 which corresponds to functionality of R.

**3.** A radiation-curable resin composition as set forth in claim 2, wherein said compound is at least one compound selected from the group consisting of;
$Y^1$-$COOCH_2$-$Y^1$, $Y^1$-$CO[O(CH_2)_5CO]OCH_2$-$Y^1$,

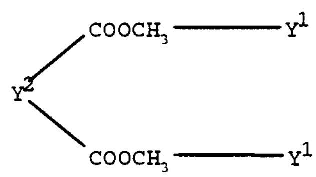

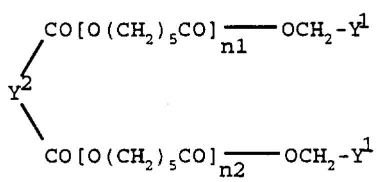

wherein n1 + n2 = average 2

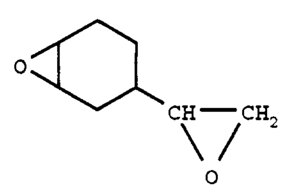

wherein $Y^1$ is a structural unit

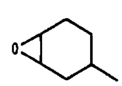 ,

and $Y^2$ is a structural unit

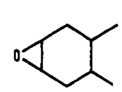 .

**4.** A radiation-curable resin composition as set forth in claim 1, wherein said epoxy compound having a (meth)acrylic group and a cycloaliphatic epoxy group is a compound represented by general formula;

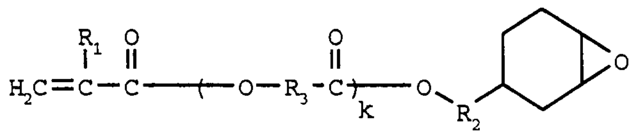

wherein $R^1$ is a hydrogen or a methyl group, $R^2$ is an alkylene group having a carbon number ranging from 1 to 10, $R^3$ is a residual group of hydrocarbon having a carbon number ranging from 1 to 10, and k is zero or an integer ranging from 1 to 10.

**5.** A radiation-curable resin composition as set forth in claim 1, wherein said cationic polymerization photo-initiators is at least one compounds selected from the group consisting of a diazonium compound, a sulfonium compound, and an iodonium compound.

**6.** A radiation-curable resin composition as set forth in claim 1, wherein said radical polymerization photo-initiators is at least one compounds selected from the group consisting of a carbonyl compound, a sulphur compound, an azo-compound, and a peroxide.

**7.** A process for coating a substrate, comprising applying a radiation-curable composition according to any one of claims 1 to 6 to the substrate and exposing the applied composition to ultraviolet light, or an electron-beam, for a period of time sufficient to form a cured coating.

**8.** A coating, varnish, paint, ink or adhesive, curable by ultraviolet radiation, or electron-beam, comprising a composition according to any one of claims 1 to 6.

**9.** A manufacture article formed using a coating, varnish, paint, ink or adhesive in accordance with claim 8.